# EUROPEAN PATENT APPLICATION

(11) **EP 4 663 354 A1**
(43) Date of publication of application: **17.12.2025**
(21) Application number: 25181814.2
(22) Date of filing: 10.06.2025
(51) Int. Cl.: B25J 9/00, B25J 9/12

(54) **A MULTI-AXIS ROBOT DEVICE**

(30) Priority: 11.06.2024 GB 202408340
(71) Applicant: Sturgeon Robotics Limited, Bathgate EH48 2UQ (GB)
(72) Inventor: Foster, Jack, Bathgate, Scotland EH48 1BP (GB)
(74) Representative: Ipconsult

(57) **Abstract**

A multi-axis robot device (10) for displacing an item comprises: a base (20) with a first foot (30) fixed thereto and a second foot (40) that is displaceable with respect to the base (20) in a first axial direction (A-A'). The first foot (30) is hingedly connected to the second foot (40) by at least one pair of linkages (50). The at least one pair of linkages (50) is attached to a support plate (60); and a coupling arm (70) connects the support plate (60) to a rotary connector (82) on a third foot (80).

The third foot (80) is displaceable with respect to the base (20) in a second axial direction (B-B') which is perpendicular to the first axial direction (A-A').

A system has actuators which include a plurality of individually addressable electromagnetic coils (200) configurable, under control of a controller (700), as a planar motor to displace, locate and hold the multi-axis robot device (10) and then to use the addressable electromagnetic coils (200) to control the operation of the multi-axis robot device (10).

## Description

### Field of the Invention

The present invention relates to a multi-axis robot device, for example of the type which is used in automated processing, manufacturing and testing systems.

### Background

Multi-axis robots are used in many tasks in industrial applications that require dexterity and precision that may be difficult or expensive for a human to perform. A robot joint represents a degree of freedom. Each degree of freedom is responsible for an independent motion in a single axis in three dimensional (3-D) space, allowing the robot to interact with its surroundings.

Articulated, multi-axis robots imitate the dexterity and movements of the human arm or hand and allow for much more complex automation, packaging and testing systems which can operate faster for longer periods and with much greater accuracy.

As the number of degrees of freedom increases, the mechanical design becomes more complex and the physical space required increases. Automated systems that can interact with several objects at once, like flying-probe machines, are often prohibitively large and expensive for smaller businesses and individuals to own.

### Prior Art

An example of a robot with a moving platform for automation is described in United States patent application US 2023/0111836 (Beckhoff Automation GmbH) which has a driven linear axis that includes a linear guide rail on which a carriage is mounted. The carriage can be moved linearly by a transport device which has a belt that is guided over drive gears.

An example of a multi-axis robot is described in United States patent application US 2022/0118634 (Beckhoff Automation GmbH) which describes an active arm module for the robot arm of a modular industrial robot and a drive device. A first connection side is mounted rotatably relative to a first housing, and is connected to the drive device in a torque-locking manner. The second connection side is connected to the first housing in a torque-proof manner.

Another example is described in WO 2018/129837 (CHENGDU ZHONGLIANGCHUANGONG TECHNOLOGY CO LTD) which discloses a robot walking mechanism.

Another example is described in CN 217669377U (UNIV ZHEJIANG SCIENCE & TECH) which discloses a remote control bionic scorpion field detection device.

Another example described in CN115078961A (UNIV HANGZHOU DIANZI) which discloses a desktop-level circuit board detection device and method based on a visual feedback mechanical arm.

The aforementioned robot systems are large and complex and often require high voltage power supplies and/or ancillary high pressure hydraulic systems, and so are not suitable for small scale applications.

The invention arose in order to provide a versatile, relatively inexpensive and low power multi-axis robot device and test system.

### Summary of the Invention

According to a first aspect of the invention there is provided a multi-axis device for displacing an item supported thereon comprising a base having a first foot fixed thereto and a second foot is adapted to be displaced with respect to the base in a first axial direction, the first foot is hingedly connected to the second foot by at least one pair of linkages, the at least one pair of linkages is attached to a support plate; a coupling arm connects the support plate to a rotary connector on a third foot, the third foot is displaceable with respect to the base in a second axial direction, which is perpendicular to the first axial direction; and the coupling arm is adapted to displace with respect to the rotary connector in an axial direction which is parallel to the first axial direction.

By displacing the first and second feet the support plate may be tilted and/or lifted. By displacing the base, the entire a multi-axis device is displaced. It is appreciated that two or more of these operations may be performed simultaneously.

According to a second aspect of the invention there is provided a multi-axis device for displacing an item supported thereon comprising a base having a first foot fixed thereto and a second foot that is displaceable along an axis that is parallel with respect to the base in a first axial direction, the first foot is hingedly connected to the second foot by at least one pair of linkages, the at least one pair of linkages is attached to a support plate; a coupling arm connects the support plate to a rotary connector on a third foot, the third foot is displaceable along an axis that is parallel with respect to the base in a second axial direction, which is perpendicular to the first axial direction in order to tilt and lift the support plate.

In preferred embodiments, at least one pair of linkages are connected to the support plate and the at least one pair hingedly connects the first leg to the second leg.

The coupling arm is ideally connected to the support plate by a rotating joint or a similar connection means.

By displacing the multi-axis device across a surface, the multi-axis device may be positioned in a precise location for example for inspection or test purposes. As the second and third foot are displaced with respect to the first foot, the first foot may be used or nominated as a datum.

One or more actuators may be provided in order to actuate or displace the base and/or at least one of the displaceable feet. In this sense the base may be displaced by way of a linear or planar actuator, such as a planar motor. The first foot may also be capable of movement, for example along an axis that is parallel to the first axial direction. Other actuators, such as brushless direct current (DC) motors or fluid powered actuators, may be located and positioned on the robot device in order to extend and/or orient a probe in a particular direction and at a specific distance from an item to be tested.

At least one of the feet has a magnetic or an electro-magnetic portion which enables the at least one foot to be anchored to a support surface by an electro-magnet. Where a magnetic portion is used, an external electromagnetic field may be generated to attract the multi-axis device, displacing the feet relative to the base and/or each other. The external electromagnetic field may be generated by one or many electromagnetic coils which act as actuators.

An advantage of the device is that it is able to be located precisely to a location and to change the position and orientation of an item or instrument supported by it, such as a test probe or camera for example. The item or instrument supported by the multi-axis device, can be manipulated in five different axes, namely x-axis, y-axis, z-axis, yaw and pitch, by changing the relative position of the feet as well as the overall position of the robot the relative position of the feet alone can only modify the pitch, z axis and some y axis. Moving the three feet in unison allows motion in the x-axis, y-axis and yaw and this can be carried out quickly and simultaneously as the device is being relocated to a different position on a planar test bed for example.

Preferably the electromagnetic drive system comprises an array of electromagnetic coils, each of which is independently addressable and is operative to displace at least a portion of at least one multi-axis device.

The array of addressable electromagnetic coils may be arranged as a planar motor comprising an rows and columns of individually addressable electromagnetic coils.

The electromagnetic coils in the array are preferably arranged in at least two layers of overlapping addressable electromagnetic coils. A controller is provided for selectively switching a defined group or a plurality of the addressable electromagnetic coils simultaneously. This is enables so called micro-stepping of one or more feet and/or the base, to be carried out whereby each coil has its current varied to achieve smooth motion of the device between first and second positions.

A planar, magnetically permeable and electrically conductive sheet is positioned between the array of addressable electromagnetic coils and supports at least one multi-axis device.

A system is therefore able to support at least one the multi-axis device and displace it/them using electromagnetic coils and when required clamp the at least one multi-axis device securely to the flat, magnetically permeable, electrically conductive sheet for example for use in testing or probing electronic circuitry.

Ideally the overlapping array of coils is formed as embedded coils in a printed circuit board.

The invention will now be described by way of example only, and with reference to the following Figures, in which:

### Brief Description of Drawings

Figure 1 shows an overall view of one embodiment of the multi-axis robot device;
Figure 2 is a side elevational view of the embodiment of multi-axis robot device as shown in Figure 1, supporting a probe;
Figure 3 shows an overall view of the embodiment of the invention shown in Figures 1 and 2 with one foot in an extended configuration;
Figure 4A shows an overall view of another embodiment of the invention and illustrates how displacement of feet, with respect to a base, affects a position and orientation of the probe;
Figures 4B and 4C, correspond to Figure 4A, and illustrate diagrammatically axial direction of movement and position of feet with respect to the base;
Figure 5 is a side elevation of the embodiment of the invention shown in Figures 1 and 2 and shows the probe tilted at an angle α with respect to a vertical;

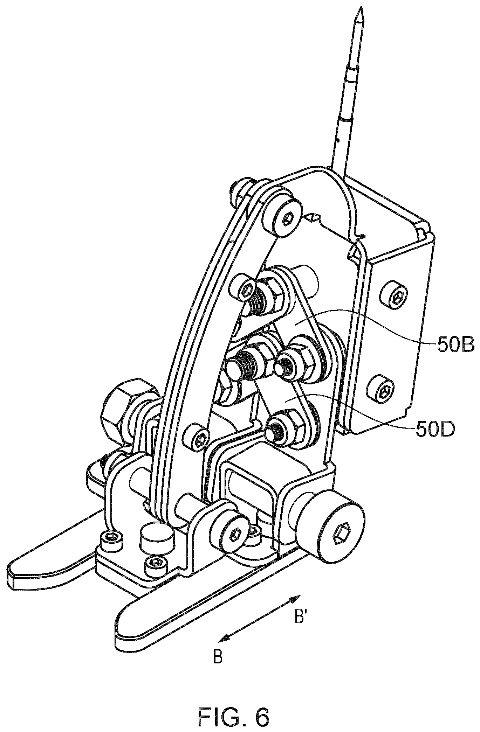

Figure 6 is an overview of the embodiment shown in Figure 5 and shows movement of a third foot in the direction of arrow B-B';
Figure 7 is a front view of the embodiment of the invention shown in Figures 1 and 2 and illustrates upper and lower pairs of linkages;
Figure 8 shows an overall view from above, of the embodiment of the invention shown in Figures 1 and 2, with one foot in a fully extended configuration so that the probe is pointing horizontally;
Figure 9 is a diagrammatical view of support bed with an array of addressable electromagnetic coils;
Figure 10 is an overall view of an embodiment of a test system with the multi-axis robot device shown in Figure 4A and the support bed;
Figure 11 is an overall diagrammatical view of two test systems for use above and below a device or circuit being tested; and
Figure 12 shows the system in Figure 11 with a controller and display for monitoring and overseeing control of each multi-axis robot device in the test system.

### Detailed Description of Preferred Embodiments of the Invention

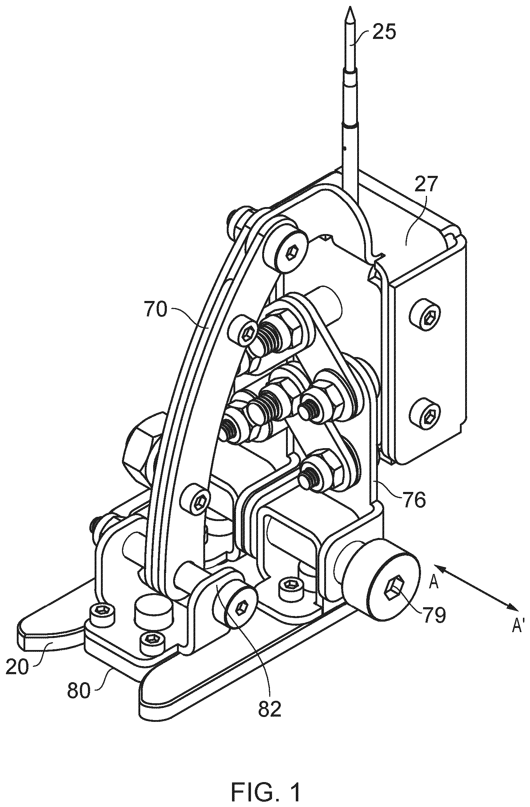

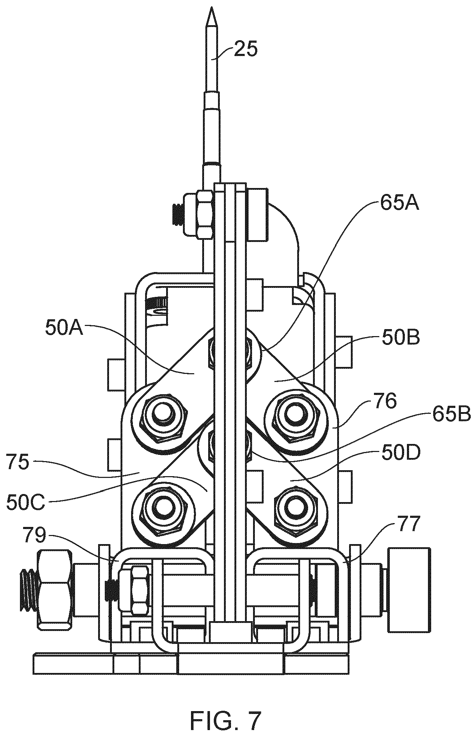

Referring to the Figures generally, and Figures 1, 2 and 3 in particular there is shown a multi-axis robot device 10 for displacing an item, such as a probe 25, supported thereon. The multi-axis robot device 10 comprises a base 20 which has a first foot 30 fixed thereto. A second foot 40 is adapted to be displaced with respect to the base 20 in a first axial direction, shown by double-headed arrow A-A'. The first foot 30 is hingedly connected to the second foot 40 by at least one pair of linkages 50 (shown in detail in Figure 7).

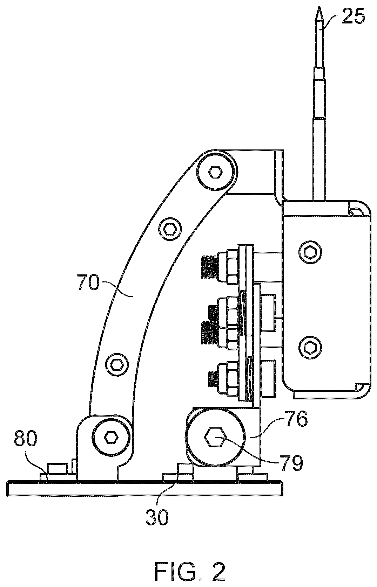

Figure 7 is a front view of the embodiment of the invention shown in Figures 1 and 2 and shows two pairs of linkages 50A and 50B and 50C and 50D connected to a support plate 60 by way of first and second rotatable connection 65A and 65B. Each pair of linkages 50 has one end attached to a respective rotatable connection 65A, 65B each of which is mounted on the support plate 60.

Ends of linkages 50A and 50C are connected to a leg 75; and the other ends of linkages 50B and 50D are connected to leg 76. Leg 75 has a rotary ankle connection 77 to the second foot 40 and leg 76 has a rotary ankle connection 79 to the first foot 30. Each foot 30 and 40 is connected to its respective ankle by way of first rotary ankle joint 79 and second rotary ankle joint 77.

Referring again to Figures 1, 2 and 3, coupling arm 70 connects the support plate 60 to a rotary connector 82 on a third foot 80. The third foot 80 is displaceable with respect to the base 20 in a second axial direction, shown by double-headed arrow B-B' which is perpendicular to the first axial A-A'. The coupling arm 70 is adapted to displace a sliding boss 83 of the rotary connector 82, in an axial direction which is parallel to the first axial direction A-A'.

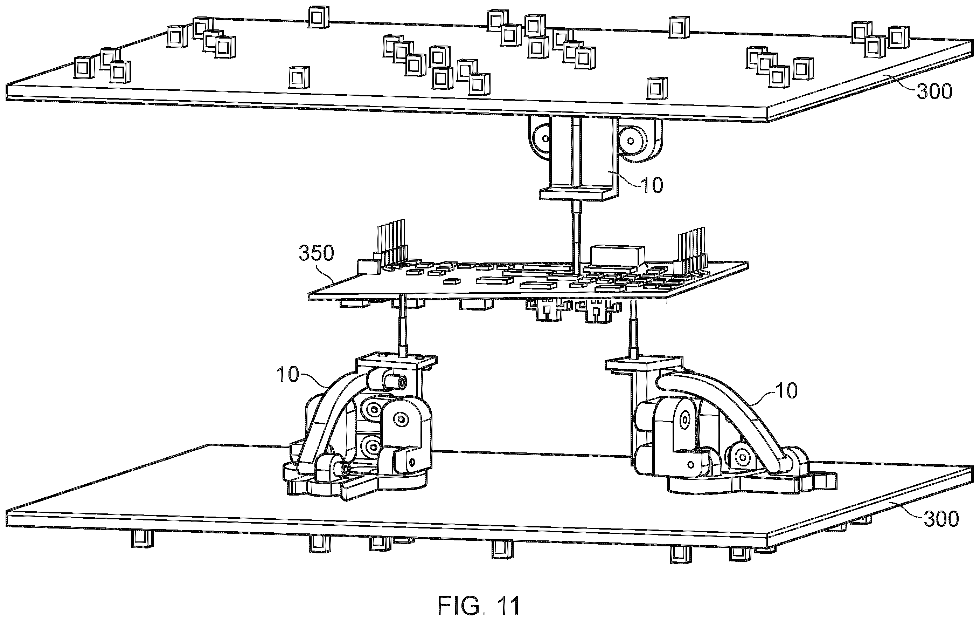

This arrangement of components ensures the second foot 40 and third foot 80 are able to be displaced simultaneously and without any component of the multi-axis robot device 10 snagging which enables the multi-axis robot device 10 to be simultaneously displaced, as explained below, and the test probe 25 oriented at the required angle and height with respect to a printed circuit board assembly 350 to be tested (as shown in Figure 11) and without any part of the probe or the multi-axis robot device 10 snagging on any piece of equipment or the circuit board to be tested.

Optionally components forming the multi-axis robot device 10 may be formed using a rapid prototype process, such as for example 3-D printing although the design also allows the components to be made from custom bent sheet metal or machined parts or moulded or pressed components.

The base 20 has two channels 35 and 85 formed therein. The channels 35, 85 have parallel sided walls and each channel defines a slot: channel 35 within which the first foot 30 is able to move in direction A-A', and channel 85 within which the third foot 80 is able to move in direction B-B'.

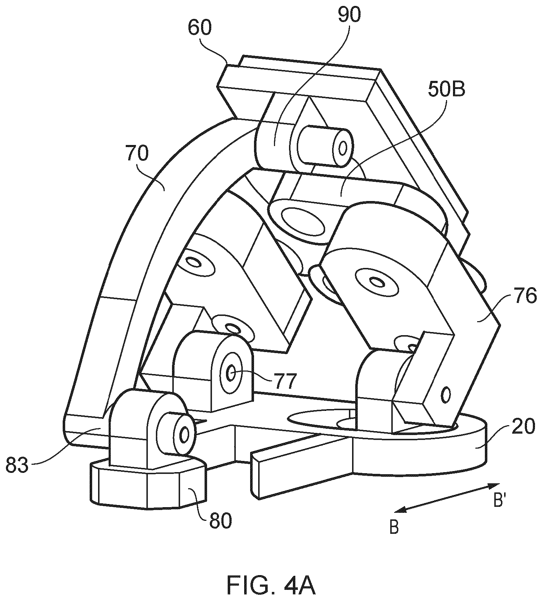

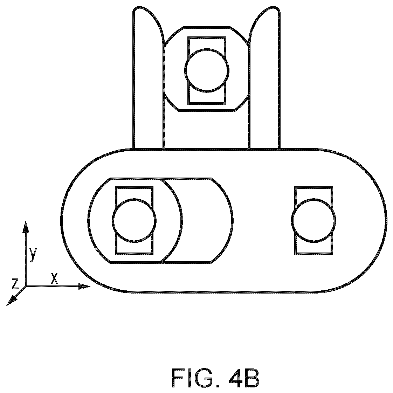

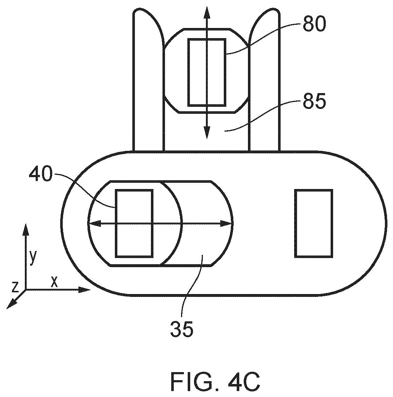

Motion of the feet 30 and 80 is shown diagrammatically in Figures 4B and 4C. When the feet 30 and 40 move relative to one another in direction of axis A-A', respective pairs of linkages 50A, 50B, 50C and 50D remain parallel as can be seen in Figure 7. It is important to note that other guides, slots or rails may be used as an alternative to the channels 85 and 35. In the embodiment shown, the feet 30, 40 and 80 are constrained to move in specific directions, either within guide channels or on rails or slides thereby ensuring that a desired motion is achieved.

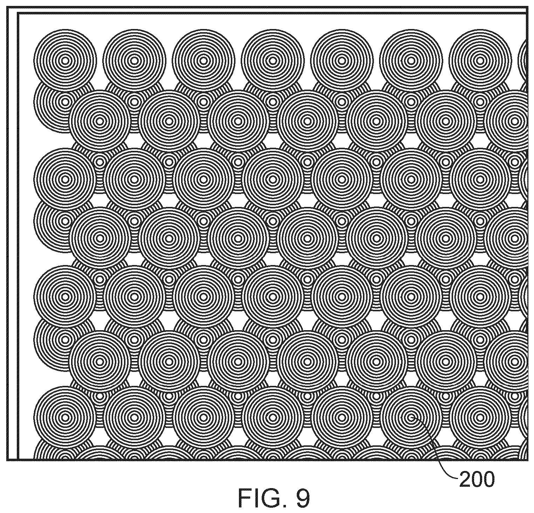

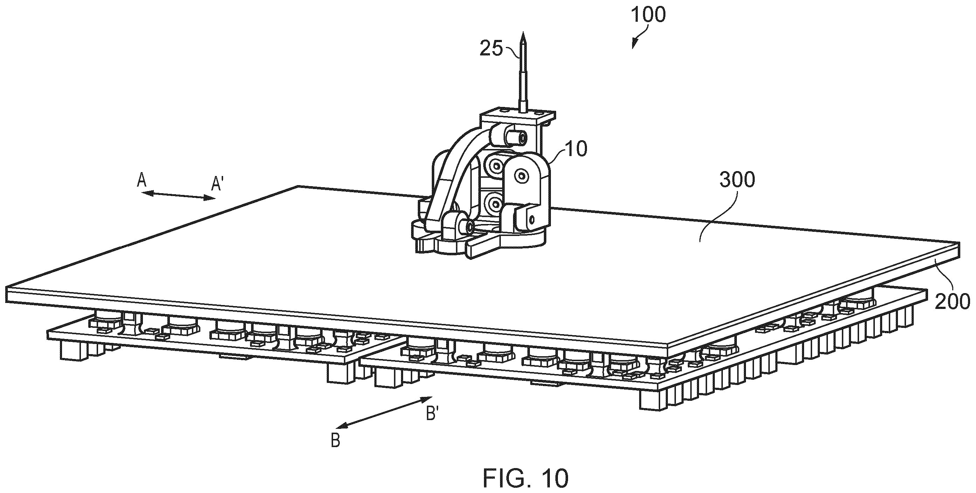

Figures 10 and 11 show examples of a system 100 for displacing an item, such as a multi-axis robot device 10 with a test probe 25 which is optionally mounted on a probe support 27, as shown in Figure 1. The multi-axis robot device 10 has a base 20 with at least one magnetic foot located therein or thereon. An array of addressable electromagnetic coils 200, as shown in Figures 9 and 10, are located below a planar magnetically permeable surface 300.

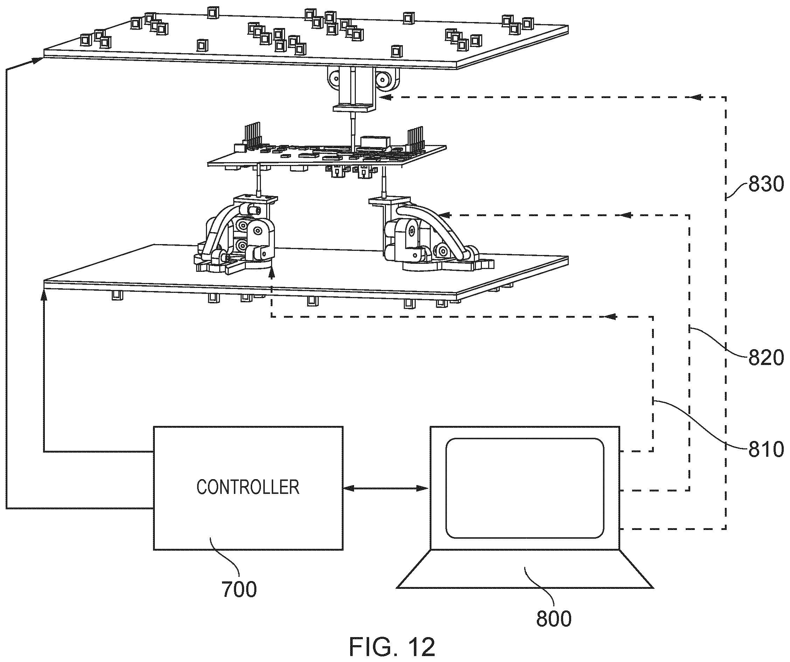

In Figure 12, connection lines 300 are shown diagrammatically contacting the printed circuit board coil 200. It is understood that in practice these control lines may be wireless channels. In Figure 10 the printed circuit board, on which the array of addressable electromagnetic coils 200 are formed, is located directly below magnetically permeable surface 300. Optionally a second sheet (not shown) supports a second printed circuit board (PCB) with another array of coils below and flush with the sheet 300.

In use selectively energising coils 200 in the array of addressable electromagnetic coils, causes the multi-axis robot device 10 to displace, across the planar magnetically permeable surface 300 to a user selected position as explained below. Coils 200 are energised in a sequential or step-like fashion under control of a coil driver printed circuit board 200 as shown diagrammatically in Figure 9.

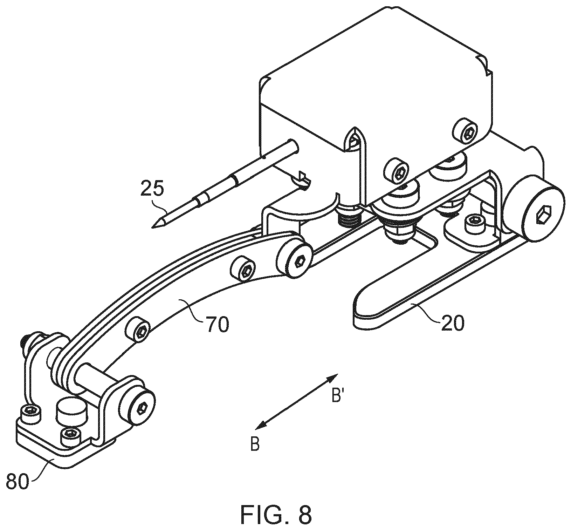

Referring to Figures 1, 8, 4B and 4C each foot 40, 80 is displaced as its magnetic field interacts with the respective magnetic fields generated under each energised coil 200. Current sensors (not shown) are arranged to detect and monitor current that is supplied to each coil. Changes in inductance in the coils can be measured by a controller 700 (shown in Figure 12) and used to detect the presence of the multi-axis robot, allowing closed loop motion control.

Figure 10 shows how the array of addressable electromagnetic coils 200 generates multiple magnetic fields that move independently to manipulate the magnets in the feet 40 and 80. The magnetic fields are used to attract the magnetic portions of the multi-axis robot 10 thereby causing it to be translated across the surface 300 above array of addressable electromagnetic coils in any orientation. This allows the robot 10 to move up walls or whilst it is in an inverted orientation, as seen in Figure 11.

The planar magnetically permeable surface 300 has low magnetic permeability so as not to distort the magnetic field. Optionally it may also have high electrical conductivity and thereby provide a clean reference point for an electronic device on the robot device 10. This also assists with electromagnet compatibility compliance as the planar sheet may be used as a shield against electromagnetic radiation.

Referring to the Figures the base 20 optionally has regions or portions of magnetic or ferro-magnetic material (not shown) formed thereon or embedded therein which are so arranged as to enable sets of selected energised coils to displace the robot linearly or to rotate the multi-axis robot device 10. Regions or portions of magnetic or ferro-magnetic material are spaced and/or offset to enable coils 200 to grab and relay, and therefore translate the multi-axis robot device 10 across the magnetically permeable surface 300.

Figures 11 and 12 show examples of a test machine, in which like parts bear the same reference numerals is in the other Figures. There is shown three robot devices 10 each with its own probe 25 operating to test component 350 from above and below simultaneously. This task is simplified and is able to be carried out faster compared to being manually tested using the system shown in which small, individual moving robots each supporting probes 25 slide across planar surfaces 300 planes. The system is capable of being made to a size that can be accommodated on a worktop or desk. This allows the possibility of automated in-house testing for smaller companies or individuals.

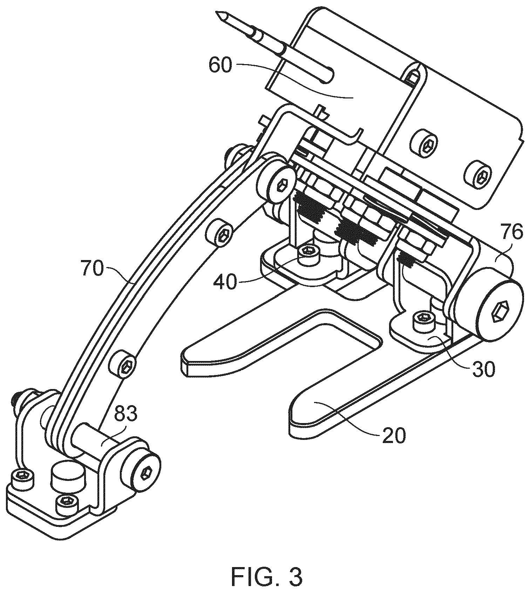

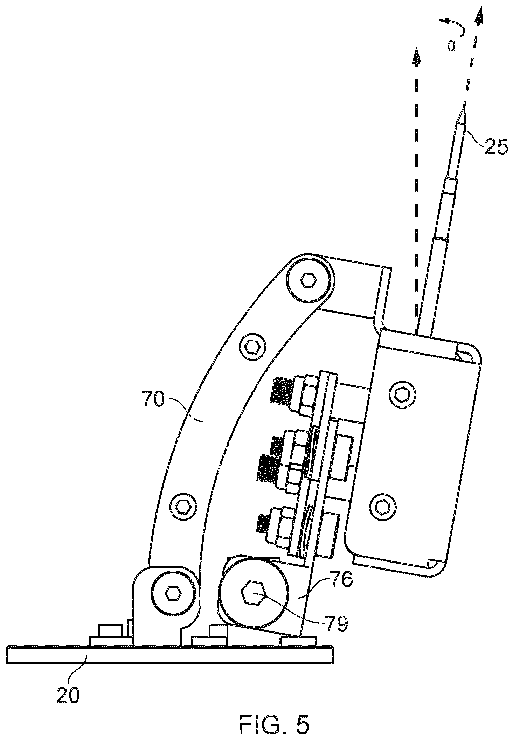

Figures 3 and 5 illustrate how axial motion of the third foot 80 with respect to the base 20 causes a tipping of the support plate 60 through an angle α.

A ground connection (not shown) is provided for the test probe through a conductive planar sheet 300. This provides a ground reference point for an onboard electronic circuit on the robot. This ground reference may be connected to onboard electronic test or measuring device, for example by using a conductive frame of the robot or through an additional grounding wire or optionally via a wireless network. The ground connection is intended to be tied to the same ground voltage as electronic device 350 or an item being tested (not shown). In this sense the ground connection is used to provide a reference for measurements made by the, or each, probe. The ground connection may also be used as a negative terminal for charging an onboard cell or supercapacitor (not shown).

Figure 12 is an overall diagrammatical view of a control system for use with the test system 100 for displacing three test probes 25 on three separate multi-axis robot devices. The system has a controller 700 which is connected to a personal computer 800 which includes a processor (not shown). Current is supplied to an upper and lower set of addressable electromagnetic coils 200 (as shown in Figure 5) in order to displace each of the multi-axis robot devices, above and below test circuit 350. Each array of addressable electromagnetic coils 200 is selectively energised in use to cause each separate multi-axis robot to displace to a user selected position.

It is appreciated that in such systems the separate multi-axis robot devices, for displacing each test probe 25, may have portions of its base that are also magnetic or ferromagnetic so that the array of addressable electromagnetic coils is operative to rotate the base of a separate multi-axis robot as well as displace it in a linear direction.

When the multi axis robots 10 are positioned in a desired position, a test current is supplied to each of the three multi axis robot devices 10, via test lines 810, 820 and 830 respectively in order to test the electrical continuity of the circuit 350 being tested.

In another embodiment onboard test or measuring devices (not shown), on the support plate of the multi-axis device, are moved by the electromagnet coils 200 and controlled by the controller 700. The onboard electronic test device (not shown) is able to carry out tests, soldering or measurements on the circuit 350 being tested and communicate results and/or receive intersections wirelessly with the main controller 700.

Figure 12 shows the system in Figure 11 with a controller 700 and personal computer with a controller in a PC 800 which has a display 850 for monitoring and overseeing control of each multi-axis robot device 10 in the test system. Control lines or channels 810, 820 and 830 represent hardwire (or wireless) connections which are operative to transfer data between the controller, such as personal computer (PC) 800, and the multi-axis robot device 10.

The invention has been described by way of examples only and it will be appreciated that variation may be made to the embodiments described, without departure from the scope of protection as defined by the claims. For example, the invention also extends to a method of deploying the separate multi-axis robots as test devices to test electrical continuity, inductance, capacitance or to act as separate lines in a data bus.

### Parts List

- 10: multi axis robot device
- 20: base
- 25: probe
- 27: probe support
- 30: first foot
- 35: first channel
- 40: second foot
- 50: linkages
- 60: support plate
- 65A, 65B: rotatable connection
- 70: coupling arm
- 75: second leg
- 76: first leg
- 77: first rotary ankle
- 79: second rotary ankle
- 80: third foot
- 82: rotary connector
- 83: sliding boss
- 85: second channel
- 90: rotary connector
- 100: system
- 200: array of addressable electromagnetic coils
- 300: magnetically permeable surface
- 350: test circuit
- 700: controller
- 800: personal computer
- 810, 820, 830: test lines

## Claims

1. A multi-axis device (10) for displacing an item supported thereon comprises: a base (20) having a first foot (30) fixed thereto and a second foot (40) is adapted to be displaced with respect to the base (20) in a first axial direction (A-A'), the first foot (30) is hingedly connected to the second foot (40) by at least one pair of linkages (50), the at least one pair of linkages (50) is attached to a support plate (60); a coupling arm (70) connects the support plate (60) to a rotary connector (82) on a third foot (80), the third foot (80) is displaceable with respect to the base (20) in a second axial direction (B-B'), which is perpendicular to the first axial direction (A-A'); and the coupling arm (70) is adapted to displace with respect to the rotary connector (82) in an axial direction which is parallel to the first axial direction (A-A').

2. A multi-axis device (10) for displacing an item supported thereon according to claim 1, wherein the second foot (40) is displaceable along an axis that is parallel with respect to the base (20) in the first axial direction (A-A'), and wherein the third foot (80) is displaceable along an axis that is parallel with respect to the base (20) in the second axial direction (B-B'), which is perpendicular to the first axial direction (A-A') in order to tilt the support plate (60).

3. A multi-axis device (10) according to claim 1 or 2 wherein a first leg (76) comprises an attachment plate that connects at least one linkage (50), on the support plate (60), to the first foot (30); and a second leg (75) comprises a second attachment plate that connects at least one linkage (50), on the support plate (60), to the second foot (40).

4. A multi-axis device (10) according to claim 3 wherein at least one pair of linkages (50) are connected to the support plate (60) and the at least one pair hingedly connects the first leg (76) to the second leg (75).

5. A multi-axis device (10) according to any preceding claim wherein the first (76) and second legs (75) are each connected to the first (30) and second feet (40) by way of respective first and second pivoting ankles.

6. A multi-axis device (10) according to any preceding claim wherein the second foot (40) is retained in a first channel (35) defined in the base (20); and/or the third foot (80) is retained in a second channel (85) defined in the base (20)..

7. A multi-axis device (10) according to any preceding claim wherein the first foot (30) includes a magnetic material; and/or the second foot (40) includes a magnetic material.

8. A system includes the multi-axis device (10) according to any preceding claim wherein an actuator is operative to displace one or more of: the base (20) and the second foot (40); and/or wherein an actuator is operative to displace the third foot (80).

9. A system according to claim 8 wherein the, or each, actuator includes a plurality of individually addressable electromagnetic coils (200).

10. A system according to claim 9 wherein the, or each, addressable electromagnetic coil (200) is configurable as part of a planar motor.

11. A system according to claim 9 or 10 wherein the addressable electromagnetic coils (200) are arranged in arrays.

12. A system according to claim 11 includes a controller (700) for selectively switching at least one of a plurality of the addressable electromagnetic coils (200).

13. A system according to claim 12 includes a magnetically permeable sheet which contacts at least one multi-axis device and allows displacement of the at least one multi-axis device with respect to the array of addressable electromagnetic coils (200).

14. A system according to any of claims 8 to 13 wherein the at least one multi-axis device (10) includes a probe (25), for example a test probe, for testing continuity of a printed circuit board.

15. A system for displacing a test probe (25) comprises: a multi-axis device (10) according to any of claims 1 to 7 which supports the test probe (25), the device (10) has a base (20) with at least one magnetic foot fixed thereto and an array of addressable electromagnetic coils (200) which in use cause the device to displace across a surface to a user selected position.

16. A method of deploying the system according to any of claims 8 to 15 for testing electrical continuity and/or measuring a characteristic of a component and/or measuring or driving an electronic signal in a circuit board.

17. A system according to claim 11 includes a controller (700) for selectively switching the multi-axis device (1) according to any of claims 1 to 7 wherein the controller (700) selectively switches the first foot (30) and the second foot (40) so as to displace them with respect one to another as the multi-axis device (10) is displaced with respect to the array of addressable electromagnetic coils (200).
